# EUROPEAN PATENT APPLICATION

(11) **EP 1 385 219 A2**
(43) Date of publication of application: **28.01.2004**
(21) Application number: 03077194.3
(22) Date of filing: 11.07.2003
(51) Int. Cl.: H01L 51/20, H01L 27/00

(54) **OLED displays with fiber-optic faceplates**

(30) Priority: 23.07.2002 US 201338
(71) Applicant: EASTMAN KODAK COMPANY, Rochester, New York 14650 (US)
(72) Inventor: Cok, Ronald S., Rochester, New York 14650-2201 (US); Burtis, John C., Rochester, New York 14650-2201 (US); Kessler, David, Rochester, New York 14650-2201 (US)
(74) Representative: Weber, Etienne Nicolas

(57) **Abstract**

An OLED display device includes a substrate; an array of OLED elements formed on the substrate; an encapsulating cover disposed over the OLED elements; and the display device being viewed through the substrate and/or the cover and wherein the substrate and/or the cover through which the display is viewed is a fiber-optic faceplate, whereby the apparent sharpness of the display device is improved

## Description

The present invention relates to the use of fiber-optic faceplates with organic light-emitting diode (OLED) flat-panel electro-optic devices and optical systems.

Organic light-emitting diodes (OLED) have many advantages in a flat-panel display device and are useful in optical systems. US 6,384,529 issued May 7, 2002 to Tang et al. shows an OLED color display that includes an array of OLED light-emitting elements (pixels). Light is emitted from a pixel when a current is passed through an organic material, the frequency of the light depending on the nature of the organic material that is used. The organic materials are placed upon a substrate between electrodes, with an encapsulating cover layer or plate. In such a display, light can be emitted through the substrate (a bottom emitter) or through the encapsulating cover (a top emitter), or both. The light emission is Lambertian, that is emitted equally in every direction While this is a useful feature in a flat-panel display because the resulting viewing angle is very wide, it is also problematic in that a significant fraction of the light emitted from the OLED materials is internally reflected within the cover or substrate and is either absorbed, light-piped to the edge of the display, or re-emitted at another location on the display. When such OLED displays are used in optical systems having large numerical apertures such as the head-mounted display shown in US 6,181,304, issued January 30, 2001 to Robinson et al., or are viewed at large viewing angles, the internal reflections in the substrate or cover plate reduce the sharpness of the display.

There is a need therefore for an improved OLED flat-panel display device with improved sharpness.

The need is met according to the present invention by providing an OLED display device that includes a substrate; an array of OLED elements formed on the substrate; an encapsulating cover disposed over the OLED elements; and the display device being viewed through the substrate and/or the encapsulating cover and wherein the substrate and/or the encapsulating cover through which the display is viewed is a fiber-optic faceplate, whereby the apparent sharpness of the display device is improved.

The present invention has the advantage that it increases the sharpness of an OLED display device when used in an optical system having a large numerical aperture or viewed from a wide viewing angle.
Fig. 1 is a cross-sectional partial view of a prior art bottom-emitter OLED display device;
Fig. 2 is a schematic diagram illustrating a prior art heads up display system having a large numerical aperture optical system;
Fig. 3 is a partial cross-sectional view of a bottom-emitter OLED display device having a fiber-optic faceplate according to the present invention;
Fig. 4 is a partial cross sectional view of a top-emitter OLED display device having a fiber-optic faceplate according to the present invention;
Fig. 5 is a partial cross sectional view of an OLED display device according to the present invention, having one fiber per light-emitting element;
Fig. 6 is a partial cross sectional view of an OLED display device according to the present invention, having one fiber for each three-color emitting subpixels;
Fig. 7 is a schematic diagram illustrating an OLED display device having a fiber-optic faceplate with a curved surface;
Fig. 8 is a graph showing an edge transition in a prior art OLED display device;
Fig. 9 is a graph showing an edge transition in an OLED display device according to the present invention;
Fig. 10 is a partial cross sectional view of a tiled display having tapered fiber-optic faceplates; and
Fig. 11 is a more detailed schematic diagram of a prior art OLED device.

The present invention is useful for both top-emitting OLED devices (those that emit light through a cover placed above a substrate on which the OLED is constructed) and bottom-emitting OLED devices (those that emit light through the substrate on which the OLED is constructed).

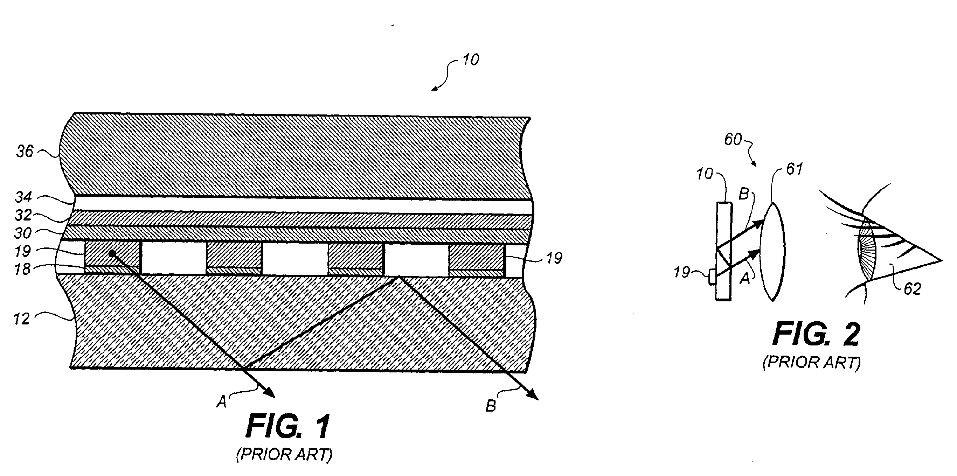

Referring to Fig. 1, a prior art bottom-emitting OLED device **10** includes a transparent substrate **12**, a first electrode **18**, regions of OLED material forming light-emitting pixels **19**, a second electrode **30**, and electrode protection layer **32**, and an encapsulating cover **36** forming a gap **34** above the protection layer **32**. Light is emitted from pixels **19** and experiences internal reflections in the substrate **12**. As shown in Fig. 2, when employed in a large numerical aperture optical system **60** such as a head-mounted display that is viewed by a human eye **62** through a large numerical aperture lens **61**, multiple images of the pixel are formed as shown by rays A and B, thereby reducing the apparent sharpness of the display. As used herein, the term large numerical aperture means a system having a numerical aperture greater than 0.25. This sharpness reducing phenomenon is also experienced when such a display is viewed normally at a large angle from the optical axis.

A top emitting device is similar to the bottom emitting device shown in Fig. 1 except that the cover **36**, the second electrode **30**, and the electrode protection layer **32** are transparent. The same problem of sharpness reducing multiple images exists.

In the Figures it is understood that, for simplicity and clarity, not all of the components or layers are shown and that the layers are not drawn to scale. In practice, the OLED layer **19**, the second electrode **30**, and the electrode protection layer **32** are very thin compared to cover **36** and substrate **12**.

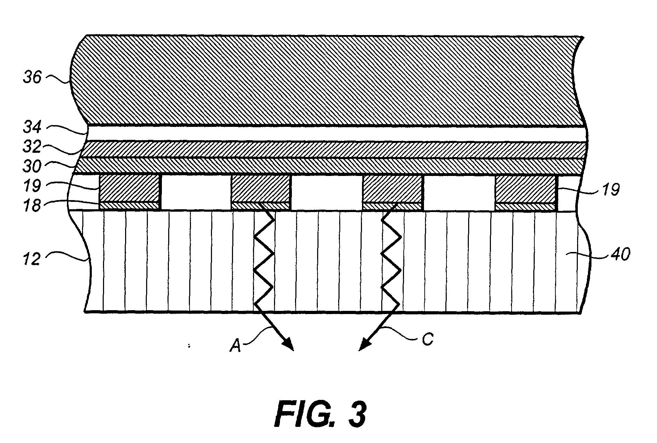

Referring to Fig. 3, in a bottom emitting display according to the present invention, substrate **12** is a fiber-optic faceplate. A fiber-optic faceplate **12** (or array of light pipes) is composed of many parallel fibers or light pipes **40**, preferably oriented orthogonal to the surface of the faceplate that transmit light through the fibers but not between fibers or from one fiber to another. Suitable fiber-optic faceplates are commercially available, for example from Schott Corporation, Yonkers, New York. Preferably the diameter of the fibers in the faceplate is approximately equal to or smaller than the diameter of the light-emitting elements in the display such that at least one fiber transmits light from each pixel in the display. Magnifying fiber-optic faceplates having tapered fibers can be used to enlarge or reduce the apparent size of the image.

The OLED elements are formed on the surface of the fiber-optic faceplate in the conventional manner. As shown in Fig. 3, light rays A and C that strike the fiber-optic faceplate cannot propagate horizontally through the substrate (as light does through a conventional glass substrate) and will emerge at or very near to the location at which the light entered the fiber-optic faceplate, thus eliminating the multiple images and enhancing the sharpness of the display.

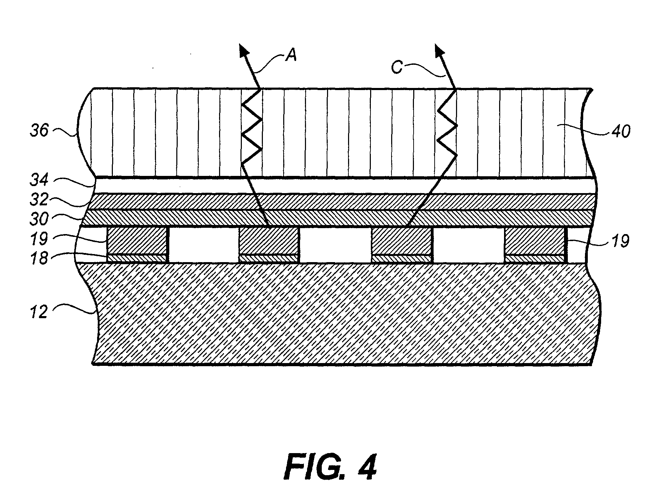

In an alternative embodiment of the present invention, a fiber-optic faceplate is used as the cover **36** of a top-emitting OLED display device. Referring to Fig. 4, the layers of the OLED device are formed conventionally on a substrate **12**, and the device is encapsulated using the fiber-optic faceplate as an encapsulating cover. In operation, the light emitted by the OLED pixels **19** traverses the gap **34** and is coupled into the fiber-optic cover from which it is emitted as described above for a bottom-emitting OLED device. Preferably, the gap **34** is filled with a transparent material having an index of refraction matching the fiber-optic face.

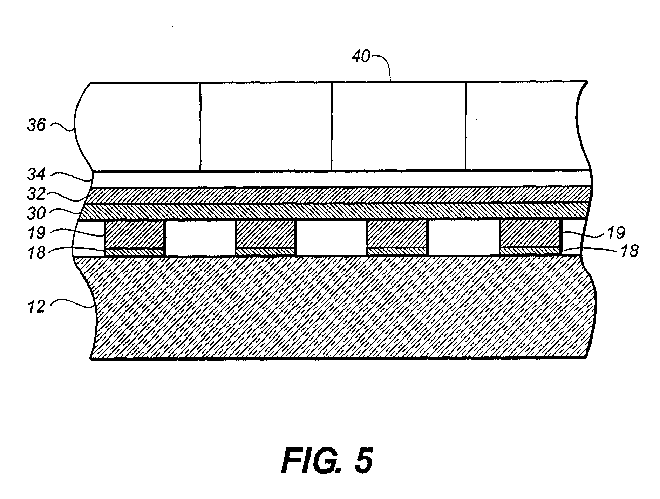

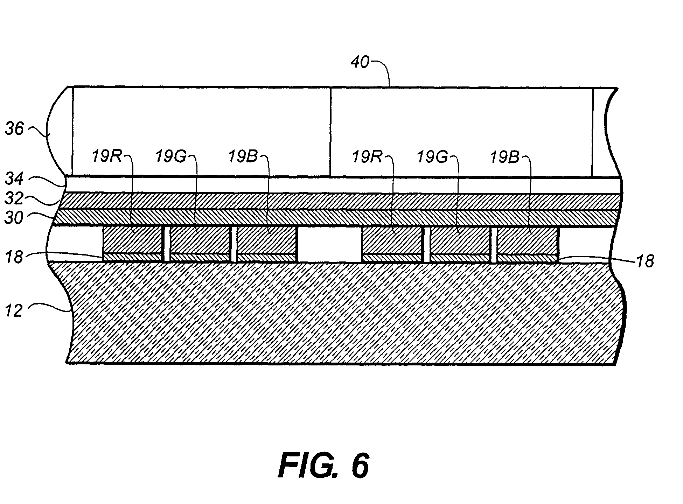

Referring to Fig. 5, the fiber-optic faceplate used as a cover **36** for a top emitter OLED display has one fiber or light pipe **40** for each light-emitting pixel element **19**. Referring to Fig. 6, the display is a color OLED display wherein each light-emitting pixel includes color subpixels **19R, 19G** and **19B,** for emitting red, green and blue light respectively. One fiber or light pipe **40** is employed for the entire three-color pixel. Alternatively, one fiber for each subpixel may be employed.

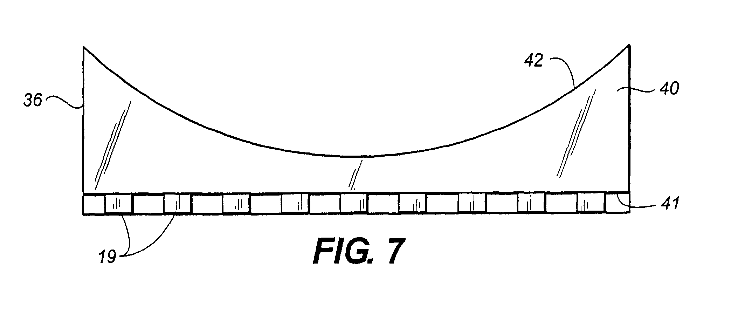

Referring to Fig. 7, according to one embodiment of the present invention, the fiber-optic faceplate is the encapsulating cover **36** and has one flat face **41** arranged adjacent to the OLED light emitters **19** and a second face **42** that is not parallel to face **41** (for example having a spherical surface as shown in the Fig. 7). This arrangement can be used in either a top or bottom emitting OLED display device. For example, a spherical wave front can be efficiently created by utilizing a fiber plate with one flat side and the other side having a spherical surface as shown in Fig. 7. The spherical surface can be, either concave or convex depending on the application in the optical system.

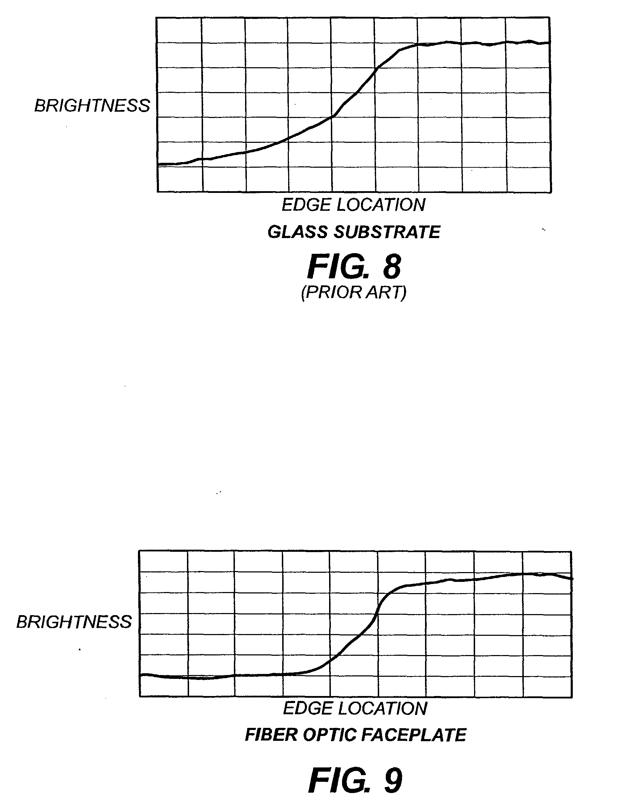

Applicants have compared the present invention with the prior art by fabricating identical bottom-emitter OLED display devices on a glass substrate and on a fiber-optic faceplate. A scan of a transition between a row of light and dark pixels on the device formed on a conventional glass substrate using a microscope having a large numerical aperture resulted in a transition having the form shown in Fig. 8. A microscopic scan of a transition between a row of light and dark pixels on the device formed on the fiber-optic faceplate resulted in a transition having the form shown in Fig. 9. As can be seen by comparing the graphs of Figs. 8 and 9, the transition measured from the display having the fiber-optic faceplate is considerably sharper. Tests were performed with the microscope objective oriented both orthogonally to the surface of the device and at an angle to the surface of the devices and similar results were obtained.

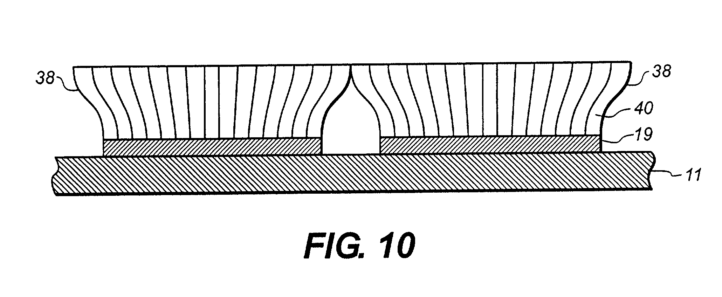

Referring to Fig. 10, display devices having tapered fiber-optic faceplates **38** can be assembled into a tiled display mounted on a support **11**. The tapered faceplate has a smaller light receiving surface adjacent the light-emitting elements and a larger light-emitting surface. The tapered fiber-optic faceplates **38** serve a dual function of improving the sharpness of the display, as discussed above, while facilitating the tiling of the display. The arrays of light-emitting elements **19** can be spaced apart from each other on the support **11**, while the edges of the fiber-optic faceplates are abutted to provide a seamless appearance to the tiled display.

The invention is preferably employed in a device that includes Organic Light-Emitting Diodes (OLEDs) which are composed of small molecule OLEDs as disclosed in but not limited to US 4,769,292, issued September 6, 1988 to Tang et al., and US 5,061,569, issued October 29, 1991 to VanSlyke et al. Many combinations and variations of organic light-emitting devices can be used to fabricate such a device.

The present invention can be employed in most OLED device configurations. These include very simple structures comprising a single anode and cathode, to more complex devices such as passive matrix displays comprised of orthogonal arrays of anodes and cathodes to form pixels, and active-matrix displays where each pixel is controlled independently, for example, with thin film transistors (TFTs).

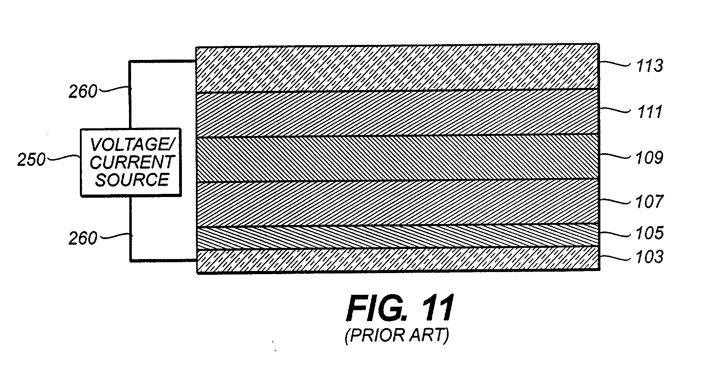

There are numerous configurations of the organic layers wherein the present invention can be successfully practiced. A typical structure is shown in Fig. 11 and is comprised of an anode **103**, a hole-injecting layer **105**, a hole-transporting layer **107**, a light-emitting layer **109**, an electron-transporting layer **111**, and a cathode **113**. These layers are described in detail below. Note that the substrate may alternatively be located adjacent to the cathode, or the substrate may actually constitute the anode or cathode. The organic layers between the anode and cathode are conveniently referred to as the organic EL element. The total combined thickness of the organic layers is preferably less than 500 nm.

The anode and cathode of the OLED are connected to a voltage/current source **250** through electrical conductors **260**. The OLED is operated by applying a potential between the anode and cathode such that the anode is at a more positive potential than the cathode. Holes are injected into the organic EL element from the anode and electrons are injected into the organic EL element at the anode. Enhanced device stability can sometimes be achieved when the OLED is operated in an AC mode where, for some time period in the cycle, the potential bias is reversed and no current flows. An example of an AC driven OLED is described in US 5,552,678 issued September 3, 1996 to Tang et al.

The OLED device of this invention is typically provided over a supporting substrate where either the cathode or anode can be in contact with the substrate. The electrode in contact with the substrate is conveniently referred to as the bottom electrode. Conventionally, the bottom electrode is the anode, but this invention is not limited to that configuration. The substrate can either be light transmissive or opaque, depending on the intended direction of light emission. The light transmissive property is desirable for viewing the EL emission through the substrate. Transparent glass or plastic is commonly employed in such cases. For applications where the EL emission is viewed through the top electrode, the transmissive characteristic of the bottom support is immaterial, and therefore can be light transmissive, light absorbing or light reflective. Substrates for use in this case include, but are not limited to, glass, plastic, semiconductor materials, silicon, ceramics, and circuit board materials. Of course it is necessary to provide in these device configurations a light-transparent top electrode.

When EL emission is viewed through anode **103**, the anode should be transparent or substantially transparent to the emission of interest. Common transparent anode materials used in this invention are indium-tin oxide (ITO), indium-zinc oxide (IZO) and tin oxide, but other metal oxides can work including, but not limited to, aluminum- or indium-doped zinc oxide, magnesium-indium oxide, and nickel-tungsten oxide. In addition to these oxides, metal nitrides, such as gallium nitride, and metal selenides, such as zinc selenide, and metal sulfides, such as zinc sulfide, can be used as the anode. For applications where EL emission is viewed only through the cathode electrode, the transmissive characteristics of anode are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable means such as evaporation, sputtering, chemical vapor deposition, or electrochemical means. Anodes can be patterned using well-known photolithographic processes. Optionally, anodes may be polished prior to application of other layers to reduce surface roughness so as to minimize shorts or enhance reflectivity.

While not always necessary, it is often useful to provide a hole-injecting layer **105** between anode **103** and hole-transporting layer **107.** The hole-injecting material can serve to improve the film formation property of subsequent organic layers and to facilitate injection of holes into the hole-transporting layer. Suitable materials for use in the hole-injecting layer include, but are not limited to, porphyrinic compounds as described in US 4,720,432, plasma-deposited fluorocarbon polymers as described in US 6,208,075, and some aromatic amines, for example, m-MTDATA (4,4',4"-tris[(3-methylphenyl)phenylamino]triphenylamine). Alternative hole-injecting materials reportedly useful in organic EL devices are described in EP 0 891 121 A1 and EP 1 029 909 A1.

The hole-transporting layer **107** contains at least one hole-transporting compound such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. in US 3,180,730. Other suitable triarylamines substituted with one or more vinyl radicals and/or comprising at least one active hydrogen containing group are disclosed by Brantley et al. in US 3,567,450 and 3,658,520.

A more preferred class of aromatic tertiary amines are those which include at least two aromatic tertiary amine moieties as described in US 4,720,432 and 5,061,569. The hole-transporting layer can be formed of a single or a mixture of aromatic tertiary amine compounds. Illustrative of useful aromatic tertiary amines are the following:
1,1-Bis(4-di-*p*-tolylaminophenyl)cyclohexane
1,1 -Bis(4-di-*p*-tolylaminophenyl)-4-phenylcyclohexane
4,4'-Bis(diphenylamino)quadriphenyl
Bis(4-dimethylamino-2-methylphenyl)-phenylmethane
N,N,N-Tri(*p*-tolyl)amine
4-(di-p-tolylamino)-4'-[4(di-*p*-tolylamino)-styryl]stilbene
N,N,N',N'-Tetra-*p*-tolyl-4-4'-diaminobiphenyl
N,N,N',N'-Tetraphenyl-4,4'-diaminobiphenyl
N,N,N',N'-tetra-1-naphthyl-4,4'-diaminobiphenyl
N,N,N',N'-tetra-2-naphthyl-4,4'-diaminobiphenyl
N-Phenylcarbazole
4,4'-Bis[N-(1-naphthyl)-N-phenylamino]biphenyl
4,4'-Bis[N-(1-naphthyl)-N-(2-naphthyl)amino]biphenyl
4,4"-Bis[N-(1-naphthyl)-N-phenylamino]p-terphenyl
4,4'-Bis [N-(2-naphthyl)-N-phenylamino]biphenyl
4,4'-Bis[N-(3-acenaphthenyl)-N-phenylamino]biphenyl
1,5-Bis[N-(1-naphthyl)-N-phenylamino]naphthalene
4,4'-Bis[N-(9-anthryl)-N-phenylamino]biphenyl
4,4"-Bis[N-(1-anthryl)-N-phenylamino]-*p*-terphenyl
4,4'-Bis[N-(2-phenanthryl)-N-phenylamino]biphenyl
4,4'-Bis[N-(8-fluoranthenyl)-N-phenylamino]biphenyl
4,4'-Bis[N-(2-pyrenyl)-N-phenylamino]biphenyl
4,4'-Bis[N-(2-naphthacenyl)-N-phenylamino]biphenyl
4,4'-Bis[N-(2-perylenyl)-N-phenylamino]biphenyl
4,4'-Bis[N-(1-coronenyl)-N-phenylamino]biphenyl
2,6-Bis(di-*p*-tolylamino)naphthalene
2,6-Bis[di-(1-naphthyl)amino]naphthalene
2,6-Bis[N-(1 -naphthyl)-N-(2-naphthyl)amino]naphthalene
N,N,N' ,N'-Tetra(2-naphthyl)-4,4"-diamino-*p*-terphenyl
4,4'-Bis {N-phenyl-N-[4-(1-naphthyl)-phenyl]amino}biphenyl
4,4'-Bis[N-phenyl-N-(2-pyrenyl)amino]biphenyl
2,6-Bis[N,N-di(2-naphthyl)amine]fluorene
1,5-Bis[N-(1-naphthyl)-N-phenylamino]naphthalene
4,4',4"-tris[(3-methylphenyl)phenylamino]triphenylamine

Another class of useful hole-transporting materials includes polycyclic aromatic compounds as described in EP 1 009 041. Tertiary aromatic amines with more than two amine groups may be used including oligomeric materials. In addition, polymeric hole-transporting materials can be used such as poly(N-vinylcarbazole) (PVK), polythiophenes, polypyrrole, polyaniline, and copolymers such as poly(3,4-ethylenedioxythiophene) / poly(4-styrenesulfonate) also called PEDOT/PSS.

As more fully described in US 4,769,292 and 5,935,721, the light-emitting layer (LEL) **109** of the organic EL element includes a luminescent or fluorescent material where electroluminescence is produced as a result of electron-hole pair recombination in this region. The light-emitting layer can be comprised of a single material, but more commonly consists of a host material doped with a guest compound or compounds where light emission comes primarily from the dopant and can be of any color. The host materials in the light-emitting layer can be an electron-transporting material, as defined below, a hole-transporting material, as defined above, or another material or combination of materials that support hole-electron recombination. The dopant is usually chosen from highly fluorescent dyes, but phosphorescent compounds, e.g., transition metal complexes as described in WO 98/55561, WO 00/18851, WO 00/57676, and WO 00/70655 are also useful. Dopants are typically coated as 0.01 to 10 % by weight into the host material. Polymeric materials such as polyfluorenes and polyvinylarylenes (e.g., poly(p-phenylenevinylene), PPV) can also be used as the host material. In this case, small molecule dopants can be molecularly dispersed into the polymeric host, or the dopant could be added by copolymerizing a minor constituent into the host polymer.

An important relationship for choosing a dye as a dopant is a comparison of the bandgap potential which is defined as the energy difference between the highest occupied molecular orbital and the lowest unoccupied molecular orbital of the molecule. For efficient energy transfer from the host to the dopant molecule, a necessary condition is that the band gap of the dopant is smaller than that of the host material. For phosphorescent emitters it is also important that the triplet energy level of the host be high enough to enable energy transfer from host to dopant.

Host and emitting molecules known to be of use include, but are not limited to, those disclosed in US 4,769,292; 5,141,671; 5,150,006; 5,151,629; 5,405,709; 5,484,922; 5,593,788; 5,645,948; 5,683,823; 5,755,999; 5,928,802; 5,935,720; 5,935,721; and 6,020,078.

Metal complexes of 8-hydroxyquinoline (oxine) and similar derivatives constitute one class of useful host compounds capable of supporting electroluminescence. Illustrative of useful chelated oxinoid compounds are the following:
CO-1: Aluminum trisoxine [alias, tris(8-quinolinolato)aluminum(III)]
CO-2: Magnesium bisoxine [alias, bis(8-quinolinolato)magnesium(II)]
CO-3: Bis[benzo{f}-8-quinolinolato]zinc (II)
CO-4: Bis(2-methyl-8-quinolinolato)aluminum(III)-□-oxo-bis(2-methyl-8-quinolinolato) aluminum(III)
CO-5: Indium trisoxine [alias, tris(8-quinolinolato)indium]
CO-6: Aluminum tris(5-methyloxine) [alias, tris(5-methyl-8-quinolinolato) aluminum(III)]
CO-7: Lithium oxine [alias, (8-quinolinolato)lithium(I)]
CO-8: Gallium oxine [alias, tris(8-quinolinolato)gallium(III)]
CO-9: Zirconium oxine [alias, tetra(8-quinolinolato)zirconium(IV)]

Other classes of useful host materials include, but are not limited to: derivatives of anthracene, such as 9,10-di-(2-naphthyl)anthracene and derivatives thereof as described in US 5,935,721, distyrylarylene derivatives as described in US 5,121,029, and benzazole derivatives, for example, 2, 2', 2"-(1,3,5-phenylene)tris[1-phenyl-1H-benzimidazole]. Carbazole derivatives are particularly useful hosts for phosphorescent emitters.

Useful fluorescent dopants include, but are not limited to, derivatives of anthracene, tetracene, xanthene, perylene, rubrene, coumarin, rhodamine, and quinacridone, dicyanomethylenepyran compounds, thiopyran compounds, polymethine compounds, pyrilium and thiapyrilium compounds, fluorene derivatives, periflanthene derivatives, indenoperylene derivatives, bis(azinyl)amine boron compounds, bis(azinyl)methane compounds, and carbostyryl compounds.

Preferred thin film-forming materials for use in forming the electron-transporting layer **111** of the organic EL elements of this invention are metal chelated oxinoid compounds, including chelates of oxine itself (also commonly referred to as 8-quinolinol or 8-hydroxyquinoline). Such compounds help to inject and transport electrons, exhibit high levels of performance, and are readily fabricated in the form of thin films. Exemplary oxinoid compounds were listed previously.

Other electron-transporting materials include various butadiene derivatives as disclosed in US 4,356,429 and various heterocyclic optical brighteners as described in US 4,539,507. Benzazoles and triazines are also useful electron-transporting materials.

When light emission is viewed solely through the anode, the cathode **113** used in this invention can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One preferred cathode material is comprised of a Mg:Ag alloy wherein the percentage of silver is in the range of 1 to 20 %, as described in US 4,885,221. Another suitable class of cathode materials includes bilayers comprising a thin electron-injection layer (EIL) in contact with the organic layer (e.g., ETL) which is capped with a thicker layer of a conductive metal. Here, the EIL preferably includes a low work function metal or metal salt, and if so, the thicker capping layer does not need to have a low work function. One such cathode is comprised of a thin layer of LiF followed by a thicker layer of A1 as described in US 5,677,572. Other useful cathode material sets include, but are not limited to, those disclosed in US 5,059,861; 5,059,862, and 6,140,763.

When light emission is viewed through the cathode, the cathode must be transparent or nearly transparent. For such applications, metals must be thin or one must use transparent conductive oxides, or a combination of these materials. Optically transparent cathodes have been described in more detail in US 4,885,211, US 5,247,190, JP 3,234,963, US 5,703,436, US 5,608,287, US 5,837,391, US 5,677,572, US 5,776,622, US 5,776,623, US 5,714,838, US 5,969,474, US 5,739,545, US 5,981,306, US 6,137,223, US 6,140,763, US 6,172,459, EP 1 076 368, US 6,278,236, and US 6,284,393. Cathode materials are typically deposited by evaporation, sputtering, or chemical vapor deposition. When needed, patterning can be achieved through many well known methods including, but not limited to, through-mask deposition, integral shadow masking, for example, as described in US 5,276,380 and EP 0 732 868, laser ablation, and selective chemical vapor deposition.

In some instances, layers **109** and **111** can optionally be collapsed into a single layer that serves the function of supporting both light emission and electron transportation. It also known in the art that emitting dopants may be added to the hole-transporting layer, which may serve as a host. Multiple dopants may be added to one or more layers in order to create a white-emitting OLED, for example, by combining blue- and yellow-emitting materials, cyan- and red-emitting materials, or red-, green-, and blue-emitting materials. White-emitting devices are described, for example, in EP 1 187 235, US 20020025419, EP 1 182 244, US 5,683,823, US 5,503,910, US 5,405,709, and US 5,283,182.

Additional layers such as electron or hole-blocking layers as taught in the art may be employed in devices of this invention. Hole-blocking layers are commonly used to improve efficiency of phosphorescent emitter devices, for example, as in US 20020015859.

This invention may be used in so-called stacked device architecture, for example, as taught in US 5,703,436 and US 6,337,492.

The organic materials mentioned above are suitably deposited through a vapor-phase method such as sublimation, but can be deposited from a fluid, for example, from a solvent with an optional binder to improve film formation. If the material is a polymer, solvent deposition is useful but other methods can be used, such as sputtering or thermal transfer from a donor sheet. The material to be deposited by sublimation can be vaporized from a sublimator "boat" often comprised of a tantalum material, e.g., as described in US 6,237,529, or can be first coated onto a donor sheet and then sublimed in closer proximity to the substrate. Layers with a mixture of materials can utilize separate sublimator boats or the materials can be pre-mixed and coated from a single boat or donor sheet. Patterned deposition can be achieved using shadow masks, integral shadow masks (US 5,294,870), spatially-defined thermal dye transfer from a donor sheet (US 5,688,551, 5,851,709 and 6,066,357) and inkjet method (US 6,066,357).

Most OLED devices are sensitive to moisture or oxygen, or both, so they are commonly sealed in an inert atmosphere such as nitrogen or argon, along with a desiccant such as alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in US 6,226,890. In addition, barrier layers such as SiOx, Teflon, and alternating inorganic/polymeric layers are known in the art for encapsulation.

OLED devices of this invention can employ various well-known optical effects in order to enhance its properties, if desired. This includes optimizing layer thicknesses to yield maximum light transmission, providing dielectric mirror structures, replacing reflective electrodes with light-absorbing electrodes, providing anti glare or anti-reflection coatings over the display, providing a polarizing medium over the display, or providing colored, neutral density, or color conversion filters over the display. Filters, polarizers, and anti-glare or anti-reflection coatings may be specifically provided over the cover or as part of the cover.

The entire contents of the patents and other publications referred to in this specification are incorporated herein by reference.

## Claims

1. An OLED display device, comprising:
a) a substrate;
b) an array of OLED elements formed on the substrate;
c) an encapsulating cover disposed over the OLED elements; and
d) the display device being viewed through the substrate and/or the encapsulating cover and wherein the substrate and/or the encapsulating cover through which the display is viewed is a fiber-optic faceplate, whereby the apparent sharpness of the display device is improved.

2. The device claimed in claim 1, wherein the fiber-optic faceplate is the substrate of the device, light is emitted through the substrate, and the encapsulating cover is opaque or reflective.

3. The device claimed in claim 1, wherein the fiber-optic faceplate is the encapsulating cover of the device, light is emitted through the encapsulating cover, and the substrate is opaque or reflective.

4. The device claimed in claim 3, wherein a gap between the encapsulating cover and the OLED elements is filled with transparent material.

5. The device claimed in claim 1, wherein the fiber-optic faceplate is flat on the side adjacent the OLED elements and the opposite side is not parallel to the flat side.

6. The device claimed in claim 5, wherein the opposite side of the fiber-optic faceplate is curved.

7. The device claimed in claim 1, wherein the fiber-optic faceplate is an image magnifying fiber-optic faceplate.

8. The device claimed in claim 7, wherein the fiber-optic faceplate enlarges the image of the device.

9. The device claimed in claim 7, wherein the fiber-optic faceplate reduces the image of the device.

10. The device claimed in claim 1, wherein the fiber-optic faceplate includes one fiber per OLED element.

11. The device claimed in claim 1, wherein the OLED elements are arranged in groups of elements, and the fiber-optic faceplate includes one fiber per group of elements.

12. The device claimed in claim 11, wherein the OLED elements in the groups are differently colored elements.

13. The device claimed in claim 1, wherein the faceplate is a tapered faceplate having a smaller light receiving surface and a larger light-emitting surface.

14. The device claimed in claim 13, wherein the device is included in a tiled display including an array of such devices, and wherein edges of the light-emitting surfaces of the faceplates are abutting.
